# EUROPÄISCHE PATENTANMELDUNG

(11) **EP 4 199 075 A1**
(43) Veröffentlichungstag der Anmeldung: **21.06.2023**
(21) Anmeldenummer: 21215164.1
(22) Anmeldetag: 16.12.2021
(51) Int. Cl.: H01L 23/427, H01L 23/367

(54) **ELEKTRONIKMODUL UMFASSEND EINE PULSIERENDE HEATPIPE MIT EINER KANALSTRUKTUR**

(71) Anmelder: Siemens Aktiengesellschaft, 80333 München (DE)
(72) Erfinder: Danov, Vladimir, 91056 Erlangen (DE); Pfefferlein, Stefan, 90562 Heroldsberg (DE); Schwarz, Florian, 90766 Fürth (DE); Stegmeier, Stefan, 81825 München (DE)
(74) Vertreter: Siemens Patent Attorneys

(57) **Zusammenfassung**

Die Erfindung betrifft ein Elektronikmodul (2), umfassend eine pulsierende Heatpipe (4) mit einer Kanalstruktur (14), in der ein Wärmetransportmedium (16) angeordnet ist, und zumindest ein elektronisches Bauelement (6), das mit dem Wärmetransportmedium (16) in einer thermisch leitfähigen Verbindung steht. Um im Vergleich zum Stand der Technik, eine verbesserte Entwärmung zu ermöglichen wird vorgeschlagen, dass die pulsierende Heatpipe (4) wenigstens einen Grundkörper (12) aufweist, in welchem die Kanalstruktur (14) zumindest teilweise ausgebildet ist, wobei der Grundkörper (12) zumindest eine Aussparung (26) aufweist, wobei in der zumindest einen Aussparung (26) jeweils eine Rippe (28, 30) befestigt ist, welche, insbesondere orthogonal, über eine Oberfläche (20) des Grundkörpers (12) hinaussteht.

## Beschreibung

Die Erfindung betrifft ein Elektronikmodul, umfassend eine pulsierende Heatpipe mit einer Kanalstruktur, in der ein Wärmetransportmedium angeordnet ist, und zumindest ein elektronisches Bauelement, das mit dem Wärmetransportmedium in einer thermisch leitfähigen Verbindung steht.

Ferner betrifft die Erfindung einen Stromrichter mit mindestens einem derartigen Elektronikmodul.

Darüber hinaus betrifft die Erfindung ein Verfahren zur Herstellung eines Elektronikmoduls, umfassend eine pulsierende Heatpipe mit einer Kanalstruktur, in der ein Wärmetransportmedium angeordnet wird, und zumindest ein elektronisches Bauelement, das mit dem Wärmetransportmedium in einer thermisch leitfähigen Verbindung steht.

Derartige Elektronikmodule kommen beispielsweise in einem Stromrichter zum Einsatz und können aktive und/oder passive elektronische Bauelemente umfassen. Ein Elektronikmodul kann unter anderem ein Leistungshalbleitermodul, ein Modul für digitale Signalverarbeitung aber auch ein Shunt-Modul sein. Unter einem Stromrichter ist beispielsweise ein Gleichrichter, ein Wechselrichter, ein Umrichter oder ein Gleichspannungswandler zu verstehen.

Mit der fortschreitenden Miniaturisierung in der Aufbau- und Verbindungstechnik, beispielsweise durch eine planare Aufbau- und Verbindungstechnik, nimmt die Leistungsdichte in Elektronikmodulen zu. Um Elektronikausfälle durch thermische Überlastungen zu vermeiden, kommt beispielsweise eine pulsierende Heatpipe (engl. pulsating heat pipe, PHP), welche auch als oszillierende Heatpipe (engl. oscillating heat pipe, OHP) bezeichnet wird, zum Einsatz. Eine pulsierende Heatpipe ist eine Vorrichtung zur Wärmeübertragung mit einer geschlossenen Kanalstruktur, in der ein Wärmetransportmedium angeordnet ist, das entlang der Kanalstruktur durch die Oberflächenspannung des Wärmetransportmediums abwechselnd Dampfsegmente und Flüssigsegmente bildet. Diese Dampf- und Flüssigsegmente werden durch einen Temperaturgradienten zum Pulsieren beziehungsweise Oszillieren angeregt. An einer Wärmequelle dehnen sich die Dampfsegmente aufgrund der höheren Temperatur aus; zudem siedet flüssiges Wärmetransportmedium dort und nimmt dabei latente Wärme auf. An einer Wärmesenke schrumpfen die Dampfsegmente durch Kondensation des gasförmigen Wärmetransportmediums und geben dabei latente Wärme ab. Die lokalen Temperatur- und Druckunterschiede treiben das ständige Pulsieren beziehungsweise Oszillieren der Dampf- und Flüssigsegmente an.

Die Offenlegungsschrift EP 3 823 018 A1 beschreibt ein Elektronikmodul. Das Elektronikmodul umfasst eine pulsierende Heatpipe mit einer Kanalstruktur, in der ein Wärmetransportmedium angeordnet ist, und wenigstens ein elektrisches Bauelement, das mit dem Wärmetransportmedium direkt in Kontakt steht und/oder mit einem elektrisch leitfähigen Kontaktelement verbunden ist, das mit dem Wärmetransportmedium direkt in Kontakt steht.

Vor diesem Hintergrund liegt der Erfindung die Aufgabe zugrunde, ein Elektronikmodul anzugeben, welches, im Vergleich zum Stand der Technik, eine verbesserte Entwärmung ermöglicht.

Diese Aufgabe wird erfindungsgemäß gelöst durch ein Elektronikmodul, umfassend eine pulsierende Heatpipe mit einer Kanalstruktur, in der ein Wärmetransportmedium angeordnet ist, und zumindest ein elektronisches Bauelement, das mit dem Wärmetransportmedium in einer thermisch leitfähigen Verbindung steht, wobei die pulsierende Heatpipe wenigstens einen Grundkörper aufweist, in welchem die Kanalstruktur zumindest teilweise ausgebildet ist, wobei der Grundkörper zumindest eine Aussparung aufweist, wobei in der zumindest einen Aussparung jeweils eine Rippe befestigt ist, welche, insbesondere orthogonal, über eine Oberfläche des Grundkörpers hinaussteht.

Ferner wird die Aufgabe erfindungsgemäß gelöst durch einen Stromrichter mit mindestens einem derartigen Elektronikmodul.

Darüber hinaus wird die Aufgabe erfindungsgemäß gelöst durch ein Verfahren zur Herstellung eines Elektronikmoduls, umfassend eine pulsierende Heatpipe mit einer Kanalstruktur, in der ein Wärmetransportmedium angeordnet wird, und zumindest ein elektronisches Bauelement, das mit dem Wärmetransportmedium in einer thermisch leitfähigen Verbindung steht, wobei die pulsierende Heatpipe wenigstens einen Grundkörper aufweist, in welchem die Kanalstruktur zumindest teilweise ausgebildet ist, wobei in den Grundkörper zumindest eine Aussparung eingebracht wird, wobei in der zumindest einen Aussparung eine Rippe befestigt wird, welche, insbesondere orthogonal über eine Oberfläche des Grundkörpers hinausstehend angeordnet wird.

Die in Bezug auf das Elektronikmodul nachstehend angeführten Vorteile und bevorzugten Ausgestaltungen lassen sich sinngemäß auf den Stromrichter und das Herstellungsverfahren übertragen.

Der Erfindung liegt die Überlegung zugrunde, eine Entwärmung zumindest eines elektronischen Bauelements in einem Elektronikmodul mit einer pulsierenden Heatpipe zu verbessern, indem zumindest eine Rippe in einen Grundkörper der pulsierenden Heatpipe eingebracht wird, über den Grundkörper hinaussteht. Ein derartiges elektronisches Bauelement kann unter anderem ein Transistor, z.B. ein Insulated-Gate-Bipolar-Transistor (IGBT) oder ein Feldeffekttransistor, ein Triac, ein Thyristor, eine Diode oder ein passives Bauelement wie ein Kondensator oder ein Widerstand, insbesondere ein Shunt-Widerstand, sein. Die pulsierende Heatpipe des Elektronikmoduls umfasst eine Kanalstruktur, die zumindest teilweise im Grundkörper ausgebildet ist. Der Grundkörper kann zumindest teilweise aus einem dielektrischen Werkstoff und/oder zumindest teilweise aus einem metallischen Werkstoff hergestellt sein. In Kanälen der Kanalstruktur ist ein Wärmetransportmedium angeordnet. Beispielsweise ist das Wärmetransportmedium Perfluor-N-alkyl-morpholin, das sich aufgrund seiner hohen Wärmeleitfähigkeit, seines Siedepunkts und seiner dielektrischen Eigenschaften gut als Wärmetransportmedium eines Elektronikmoduls eignet.

Das zumindest eine elektronische Bauelement steht mit dem Wärmetransportmedium in einer thermisch leitfähigen Verbindung, sodass vom elektronischen Bauelement ausgehende Wärme in das Wärmetransportmedium einkoppelbar ist. Der Grundkörper weist zumindest eine Aussparung auf, wobei in der zumindest einen Aussparung eine Rippe befestigt ist, welche, insbesondere orthogonal, über eine Oberfläche des Grundkörpers hinaussteht. Die Rippe kann auch als Lamelle bezeichnet werden und zumindest teilweise aus einem dielektrischen Werkstoff und/oder zumindest teilweise aus einem metallischen Werkstoff hergestellt sein. Ferner kann die Rippe unter anderem quaderförmig ausgeführt sein. In einer Aussparung können auch zwei oder mehrere Rippen angeordnet sein. Die Rippen können unter anderem in einem aus einem Kunststoff gefertigten Grundkörper vergossen, in den Grundkörper eingepresst oder über eine stoffschlüssige, insbesondere fluiddichte, Verbindung mit dem Grundkörper verbunden sein. Die in einer Aussparung angeordneten Rippen können sich, z.B. hinsichtlich ihrer Geometrie, ihrer elektrischen Leitfähigkeit und/oder ihrer thermischen Leitfähigkeit unterscheiden. Die Oberfläche kann auf einer Außenfläche oder einer Innenfläche des Grundkörpers, insbesondere im Bereich der Kanalstruktur, angeordnet sein. Somit kann die Rippe unter anderem in die Kanalstruktur ragen und/oder über die Außenfläche des Grundkörpers hinausstehen. Eine über den Grundkörper hinausstehende Rippe führt zu einer Oberflächenvergrößerung, was eine Wärmeübertragung an die Umgebung und damit eine Entwärmung verbessert. Somit kann durch eine in den Grundkörper eingebrachte Rippe eine effiziente Wärmeeinkopplung bzw. Wärmeauskopplung erreicht werden.

Eine weitere Ausführungsform sieht vor, dass die Rippe aus einem Werkstoff hergestellt ist, welcher eine höhere Wärmeleitfähigkeit aufweist als ein Werkstoff des Grundkörpers. Unter anderem kann der Grundkörper aus einem Polymer hergestellt sein, während die Rippe aus einem keramischen Werkstoff, beispielsweise Aluminiumoxid, hergestellt ist. Die Rippe kann auf diese Weise als Wärmeleitstruktur fungieren, sodass eine verbesserte Wärmeeinkopplung bzw. Wärmeauskopplung erreichbar ist. Ferner wird durch die höhere Wärmeleitfähigkeit eine effizientere Entwärmung erreichbar.

Eine weitere Ausführungsform sieht vor, dass die Rippe aus einem metallischen Werkstoff hergestellt ist. Beispielsweise enthält die Rippe Kupfer, Silber und/oder Aluminium. Derartige metallische Werkstoffe weisen eine hohe Wärmeleitfähigkeit auf, wodurch eine effizientere Entwärmung erreichbar ist.

Eine weitere Ausführungsform sieht vor, dass die metallische Rippe einer metallischen Wärmesenke zugeordnet ist. Beispielsweise wird eine metallische Wärmesenke durch eine Mehrzahl, insbesondere parallel zueinander angeordneter, metallischer Rippen ausgebildet, welche einen Übergang zu einer Kühlfluidströmung herstellen. Aufgrund der Oberflächenvergrößerung durch die metallischen Rippen wird eine effizientere Entwärmung erreicht.

Eine weitere Ausführungsform sieht vor, dass die Rippe in direktem Kontakt mit dem Wärmetransportmedium steht. Beispielsweise erstreckt sich die Rippe in zumindest einen Kanal der Kanalstruktur. Insbesondere bei Verwendung einer metallischen Rippe wird ein verbesserter Wärmeübergang erreicht.

Eine weitere Ausführungsform sieht vor, dass zumindest eine Rippe beidseitig über den Grundkörper hinaussteht. Insbesondere steht zumindest eine Rippe über gegenüberliegende Oberflächen des Grundkörpers hinaus, sodass sich die Oberfläche zusätzlich vergrößert, was eine Wärmeübertragung an die Umgebung zusätzlich verbessert.

Eine weitere Ausführungsform sieht vor, dass der Grundkörper der pulsierenden Heatpipe zumindest teilweise aus einem dielektrischen Werkstoff hergestellt ist, wobei das zumindest eine elektronische Bauelement über die pulsierende Heatpipe mit einer metallischen Wärmesenke elektrisch isolierend und thermisch leitend verbunden ist. Der aus einem dielektrischen Werkstoff hergestellte Grundkörper ermöglicht eine elektrische Isolation des elektronischen Bauelements von der metallischen Wärmesenke. Durch den Einsatz einer elektrisch isolierenden Flüssigkeit für die 2-Phasen-Kühlung kann eine zusätzliche bzw. verbesserte elektrische Trennung erreicht werden. Insbesondere bei einem Elektronikmodul mit vertikalen Leistungshalbleitern, wie z.B. IGBTs, kann auf eine dedizierte Isolationsschicht, welche üblicherweise durch ein DCB-Substrat bereitgestellt wird, verzichtet werden, was zusätzlich Kosten einspart.

Eine weitere Ausführungsform sieht vor, dass die zumindest eine Aussparung im dielektrischen Werkstoff des Grundkörpers verlaufend angeordnet ist. Insbesondere bei Verwendung einer metallischen Rippe wird ein verbesserter Wärmeübergang erreicht.

Eine weitere Ausführungsform sieht vor, dass der Grundkörper zumindest teilweise fluiddicht beschichtet ist. Der dielektrische Werkstoff des Grundkörpers, beispielsweise ein Polymer, kann für das Wärmetransportmedium, das in der pulsierenden Heatpipe Dampf- und Flüssigsegmente ausbildet, durchlässig sein, sodass sich das Wärmetransportmedium durch den dielektrischen Werkstoff des Grundkörpers verflüchtigen kann. Um ein Verflüchtigen des Wärmetransportmediums zu verhindern, wird der Grundkörper zumindest teilweise fluiddicht beschichtet. Somit kann im Bereich des Grundkörpers auf kostenintensive metallische Werkstoffe ohne merkliche Beeinflussung der Heatpipe verzichtet werden.

Eine weitere Ausführungsform sieht vor, dass der Grundkörper zumindest teilweise mit einem metallischen, keramischen Werkstoff und/oder glasartigen Werkstoff beschichtet ist. Keramische und glasartige Werkstoffe weisen gute Isolationseigenschaften auf und ermöglichen auch bei sehr geringen Schichtdicken im Bereich von 5-50 µm eine ausreichende Dichtigkeit. Insbesondere ein glasartiger Werkstoff, beispielsweise Siliziumdioxid, kann mittels eines CVD-Verfahrens, insbesondere mittels eines PACVD- Verfahrens (plasma-enhanced chemical vapour deposition, plasmaunterstützte chemische Gasphasenabscheidung) auf einen thermisch stabilen Kunststoff aufgebracht werden, da ein derartiges Verfahren typischerweise bei 200°C bis 500°C stattfinden kann und so der Kunststoff nicht zerstört wird. Eine Beschichtung mit einem metallischen Werkstoff, z.B. Kupfer, Gold, Silber, kann unter anderem durch Heißprägen, ein PVD-Verfahren, insbesondere Sputtern, oder galvanisch aufgebracht werden. Derartige Verfahren sind einfach und kostengünstig. Durch Metallisierungsdicken im Bereich von 5-50 µm wird ein Verflüchtigen des Wärmetransportmediums effektiv verhindert.

Eine weitere Ausführungsform sieht vor, dass der Grundkörper der pulsierenden Heatpipe zumindest einen fluiddicht ausgeführten Isolationskörper umfasst. Ein derartiger fluiddicht ausgeführter Isolationskörper kann unter anderem aus einem keramischen Werkstoff hergestellt sein und ermöglicht eine elektrische Isolation des elektronischen Bauelements von der metallischen Wärmesenke. Insbesondere bei einem Elektronikmodul mit vertikalen Leistungshalbleitern, wie z.B. IGBTs, kann auf eine dedizierte Isolationsschicht, welche üblicherweise durch ein DCB-Substrat bereitgestellt wird, verzichtet werden, was zusätzlich Kosten einspart. Ferner wird durch den fluiddicht ausgeführten Isolationskörper ein Verflüchtigen des Wärmetransportmediums effektiv verhindert.

Eine weitere Ausführungsform sieht vor, dass das zumindest eine elektronische Bauelement über einen Metallschaum mit dem Wärmetransportmedium in Kontakt steht. Das elektronische Bauelement kann hierbei über den Metallschaum in direktem Kontakt mit dem Wärmetransportmedium stehen oder, beispielsweise über ein elektrisch leitfähiges Kontaktelement, mit dem Metallschaum kontaktiert sein, welcher mit dem Wärmetransportmedium in direktem Kontakt steht. Ein derartiger, insbesondere offenporiger, Metallschaum, welcher beispielsweise mittels eines LCS-Prozesses (Lost Carbonate Sintering) herstellbar ist, kann unter anderem Kupfer enthalten und vom Wärmetransportmedium durchströmt werden. Somit wird die thermische Anbindung des elektronischen Bauelements an die Heatpipe verbessert.

Eine weitere Ausführungsform sieht vor, dass zumindest eine, insbesondere metallische, Rippe durch den Metallschaum verlaufend angeordnet ist und in direktem Kontakt mit dem Wärmetransportmedium steht. Durch eine derartige Anordnung wird die thermische Anbindung des elektronischen Bauelements an die Heatpipe zusätzlich verbessert.

Eine weitere Ausführungsform sieht vor, dass zumindest eine Rippe kraftschlüssig, insbesondere über eine Pressverbindung, in einer Aussparung befestigt ist. Eine derartige kraftschlüssige Verbindung ist einfach und kostengünstig herstellbar.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausführungsform eines Elektronikmoduls in einem Querschnitt,
- FIG 2: eine schematische Darstellung einer zweiten Ausführungsform eines Elektronikmoduls in einem Querschnitt,
- FIG 3: eine schematische Darstellung einer dritten Ausführungsform eines Elektronikmoduls in einem Querschnitt,
- FIG 4: eine schematische Darstellung einer vierten Ausführungsform eines Elektronikmoduls in einem Querschnitt,
- FIG 5: eine schematische Darstellung einer fünften Ausführungsform eines Elektronikmoduls in einem Querschnitt,
- FIG 6: eine schematische Darstellung eines Grundkörpers einer pulsierenden Heatpipe in einem Querschnitt,
- FIG 7: eine schematische Darstellung des Grundkörpers in einem Längsschnitt,
- FIG 8: eine schematische Darstellung eines ersten Verfahrens zur Befestigung einer Rippe in einer Aussparung eines Grundkörpers einer pulsierenden Heatpipe zur Herstellung eines Elektronikmoduls,
- FIG 9: eine schematische Darstellung eines zweiten Verfahrens zur Befestigung einer Rippe in einer Aussparung eines Grundkörpers einer pulsierenden Heatpipe zur Herstellung eines Elektronikmoduls,
- FIG 10: einen Ausschnitt einer sechsten Ausführungsform eines Elektronikmoduls in einer schematischen Querschnittsdarstellung,
- FIG 11: einen Ausschnitt einer siebten Ausführungsform eines Elektronikmoduls in einer schematischen Querschnittsdarstellung,
- FIG 12: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

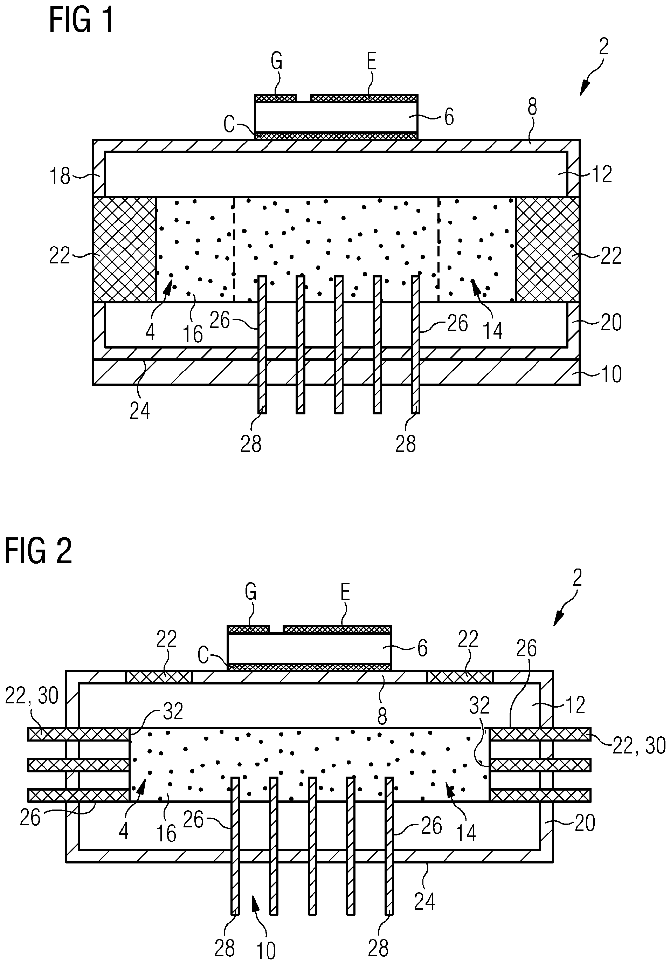

FIG 1 zeigt eine schematische Darstellung einer ersten Ausführungsform eines Elektronikmoduls 2 in einem Querschnitt, welches eine pulsierende Heatpipe 4 und ein elektronisches Bauelement 6 umfasst. Beispielhaft ist das elektronische Bauelement 6 als ein Insulated-Gate-Bipolar-Transistor (IGBT) ausgeführt. Weitere Beispiele für derartige elektronische Bauelemente 6 sind andere Transistortypen wie Feldeffekttransistoren, Triacs, Thyristoren, Dioden sowie passive Bauelemente wie Kondensatoren oder Widerstände, insbesondere Shunt-Widerstände. Der IGBT umfasst einen Steueranschluss, welcher als Gate-Anschluss G ausgeführt ist, sowie Lastanschlüsse, welche als Kollektor-Anschluss C und Emitter-Anschluss E ausgeführt sind. Der IGBT ist kollektorseitig auf einem elektrisch leitfähigen Kontaktelement 8 kontaktiert, welches als Metallisierung ausgeführt ist, die beispielsweise Kupfer enthält. Insbesondere ist der IGBT stoffschlüssig, beispielsweise durch eine Lötverbindung oder durch eine Sinterverbindung, mit der Metallisierung verbunden. Das elektronische Bauelement 6 fungiert als Wärmequelle, wobei ein Wärmetransport ausgehend von der Wärmequelle über die pulsierende Heatpipe 4 hin zu einer Wärmesenke 10 stattfindet. Der Wärmeeintrag erfolgt über das elektrisch leitfähige Kontaktelement 8. Der Gate-Anschluss G und der Emitter-Anschluss E können unter anderem stoffschlüssig, z.B. mittels Löten und/oder Sintern, mit einem Substrat, welches aus Gründen der Übersichtlichkeit in FIG 1 nicht dargestellt ist, verbunden werden.

Die pulsierende Heatpipe 4 weist einen Grundkörper 12 auf, in der eine planare Kanalstruktur 14 ausgebildet ist, welche einen, insbesondere mäanderartig verlaufenden, geschlossenen Kanal umfasst. In FIG 1 ist die Kanalstruktur 14 vollständig im Grundkörper 12 ausgebildet. Innerhalb der Kanalstruktur 14 ist ein Wärmetransportmedium 16 angeordnet. Das Wärmetransportmedium 16 bildet entlang des, insbesondere mäanderartig, verlaufenden geschlossenen Kanals abwechselnd Dampfsegmente, in denen das Wärmetransportmedium 16 in einer gasförmigen Phase vorliegt, und Flüssigsegmente, in denen das Wärmetransportmedium 16 in einer gasförmigen Phase vorliegt. Die Dampfsegmente und Flüssigsegmente werden in dem Kanal durch Temperaturgradienten zu pulsierenden beziehungsweise oszillierenden Bewegungen angeregt. Beispielsweise ist das Wärmetransportmedium 16 Perfluor-N-alkyl-morpholin, das sich aufgrund seiner hohen Wärmeleitfähigkeit, seines Siedepunkts und seiner dielektrischen Eigenschaften gut als Wärmetransportmedium 16 eines Elektronikmoduls 2 eignet.

Der Grundkörper 12 der pulsierenden Heatpipe 4 ist aus einem dielektrischen Werkstoff hergestellt, der unter anderem ein Polymer, z.B. Polypropylen, enthalten kann. Derartige Polymere weisen können gasdurchlässig sein. Eine metallische fluiddichte Beschichtung 18, welche auf einer Oberfläche 20 des Grundkörpers 12 verlaufend angeordnet ist, verhindert ein Verflüchtigen des Wärmetransportmediums 16 durch den dielektrischen Werkstoff des Grundkörpers 12. Das elektrisch leitfähige Kontaktelement 8 ist Teil der metallischen fluiddichten Beschichtung 18 des Grundkörpers 12. Ferner ist die metallische fluiddichte Beschichtung 18 der Oberfläche 20 des Grundkörpers 12, insbesondere stoffschlüssig, mit der Wärmesenke 10 verbunden, wobei eine derartige Verbindung unter anderem durch Löten oder Sintern herstellbar ist. Besonders gut sind Kupfer, Silber, Gold oder eine Legierung, welche mindestens eines dieser Metalle enthält, zum Beschichten geeignet. Der metallische Werkstoff kann unter anderem durch thermisches Metallsprühen, insbesondere durch Kaltgasspritzen, Plasmasprühen, PVD, Heißpressen, oder mittels Galvanik aufgebracht werden. Typische Schichtdicken des metallischen Werkstoffs liegen beispielsweise im Bereich von 10 µm bis 50 µm. Beim Aufbringen einer metallischen fluiddichten Beschichtung 18 mittels Galvanik ist es unter Umständen vorteilhaft, wenn bei dem zuvor genannten Polymer des Grundkörpers 12 eine Schicht eines Katalysators, beispielsweise Palladium, zumindest im Bereich der Beschichtung 18, vorgesehen ist. Dieser ermöglicht ein direktes Anwachsen des Metalls an das Polymer des Grundkörpers 12. Beispielsweise wird ein Polymer wie ABS oder PA mit einem metallischen Werkstoff beschichtet, wobei der metallische Werkstoff durch chemische Behandlung des Polymers, katalytische Aktivierung und nachfolgender galvanischer Metallisierung, z.B. mit Kupfer, Nickel und/oder Chrom, aufgebracht wird. Beispielsweise wird der dielektrische Grundkörper 12 mittels Spritzguss hergestellt und in einem darauffolgenden Schritt die metallische fluiddichte Beschichtung 18 aufgebracht.

In FIG 1 ist das elektronische Bauelement 6 über einen fluiddicht ausgeführten Isolationskörper 22 und ein elektrisch isolierend ausgeführtes Wärmetransportmedium 16, z.B. Perfluor-N-alkyl-morpholin, der pulsierenden Heatpipe 4 mit der metallischen Wärmesenke 10 elektrisch isolierend und thermisch leitend verbunden. Ein derartiger fluiddicht ausgeführter Isolationskörper 22 kann unter anderem aus einem keramischen oder glasartigen Werkstoff, z.B. Aluminiumoxid oder Siliziumdioxid, hergestellt sein. Beispielsweise wird der fluiddicht ausgeführte Isolationskörper 22 mit dem Grundkörper 12 durch eine adhäsive Verbindung, insbesondere über einen thermisch leitfähigen Klebstoff, verbunden. Unter anderem bei einem Elektronikmodul 2 mit einem vertikalen Leistungshalbleiter, wie z.B. einem IGBT, kann durch eine derartige Anordnung auf eine dedizierte Isolationsschicht, welche üblicherweise durch ein DCB-Substrat bereitgestellt wird, verzichtet werden.

Der Grundkörper 12 weist auf einer dem elektronischen Bauelement 6 abgewandten Seite 24 Aussparungen 26 auf, in welchen jeweils eine metallische Rippe 28 befestigt ist. Die metallischen Rippen 28 sind beispielsweise aus Kupfer, Aluminium oder eine Legierung, welche mindestens eines dieser Metalle enthält, hergestellt und stehen orthogonal über die Oberfläche 20 des Grundkörpers 12 hinaus. Somit weisen die metallischen Rippen 28 eine höhere Wärmeleitfähigkeit auf als der Grundkörper 12 und fungieren als oberflächenvergrößernde Wärmeleitstrukturen. Weiterhin sind die metallischen Rippen 28 orthogonal in die Kanalstruktur 14 verlaufend angeordnet, sodass die metallischen Rippen 28 in direktem Kontakt mit dem Wärmetransportmedium 16 stehen. Die metallischen Rippen sind der metallischen Wärmesenke 10 zugeordnet.

Die metallischen Rippen 28 können unter anderem im dielektrischen Grundkörper 12 vergossen, in den Grundkörper 12 eingepresst oder über eine stoffschlüssige, insbesondere fluiddichte, Verbindung mit dem Grundkörper 12 verbunden sein. Darüber hinaus sind die metallischen Rippen 28 in FIG 1, insbesondere stoffschlüssig, mit der metallischen Wärmesenke 10 verbunden.

FIG 2 zeigt eine schematische Darstellung einer zweiten Ausführungsform eines Elektronikmoduls 2 in einem Querschnitt. Die metallische fluiddichte Beschichtung 18, welche das elektrisch leitfähige Kontaktelement 8 umfasst, weist im Bereich des elektronischen Bauelements 6 fluiddicht ausgeführte Isolationskörper 22 auf, welche die Metallisierung elektrisch unterbrechen aber dennoch ein Entweichen des Wärmetransportmediums 16 verhindern. Dielektrische Rippen 30, welche unter anderem aus einem keramischen Werkstoff, wie Aluminiumoxid, hergestellt sein können und als Isolationskörper 22 ausgeführt sind, sind in Aussparungen 26 des Grundkörpers 12 angeordnet. Somit weisen die dielektrischen Rippen 30 eine höhere Wärmeleitfähigkeit auf als der beispielsweise aus einem Polymer hergestellte Grundkörper 12. Die dielektrischen Rippen 30 stehen zumindest über eine Kontaktfläche 32 in direktem Kontakt mit dem Wärmetransportmedium 16 und stehen orthogonal über die Oberfläche 20 des Grundkörpers 12 hinaus. Daher fungieren die dielektrischen Rippen 30 neben ihrer Isolationsfunktion als oberflächenvergrößernde Wärmeleitstrukturen. Durch die metallischen Rippen 28 wird in FIG 2 die metallische Wärmesenke 10 ausgebildet. Die weitere Ausgestaltung des Elektronikmoduls 2 in FIG 2 entspricht der in FIG 1.

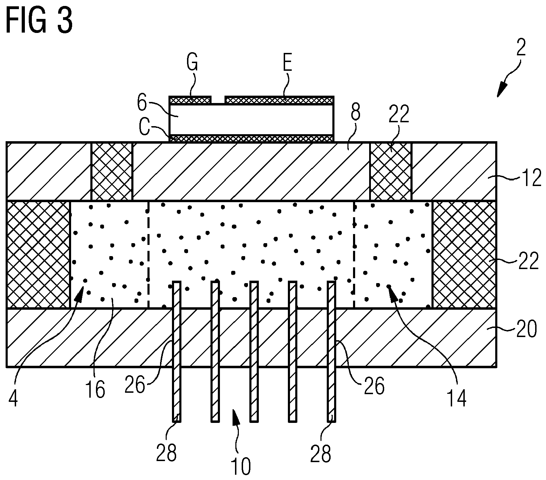

FIG 3 zeigt eine schematische Darstellung einer dritten Ausführungsform eines Elektronikmoduls 2 in einem Querschnitt, wobei der Grundkörper 12 aus einem metallischen Werkstoff wie Aluminium, Kupfer oder einer Legierung, welche mindestens eines dieser Metalle enthält, hergestellt ist. Das als IGBT ausgeführte elektronische Bauelement 6 ist kollektorseitig auf einem elektrisch leitfähigen Kontaktelement 8 kontaktiert, welches Teil des metallischen Grundkörpers 12 ist. Darüber hinaus ist die Kanalstruktur 14 der pulsierenden Heatpipe 4 ist vollständig im metallischen Grundkörper 12, welcher durch Isolationskörper 22 unterbrochen ist, ausgebildet. Die metallischen Rippen 28 sind in Aussparungen 26 des Grundkörpers 12 angeordnet und sind, insbesondere stoffschlüssig, mit dem Grundkörper 12 verbunden. Alternativ können die metallischen Rippen 28 unter anderem in den Grundkörper 12 eingepresst sein. Das elektronische Bauelement 6 ist über die fluiddicht ausgeführten Isolationskörper 22 und das elektrisch isolierend ausgeführte Wärmetransportmedium 16, z.B. Perfluor-N-alkyl-morpholin, elektrisch isolierend und thermisch leitend mit der metallischen Wärmesenke 10 verbunden. Die metallische Wärmesenke 10 wird in FIG 3 durch die metallischen Rippen 28 und den vom elektronische Bauelement 6 elektrisch isolierten Teil des metallischen Grundkörpers 12 ausgebildet. Die weitere Ausgestaltung des Elektronikmoduls 2 in FIG 3 entspricht der in FIG 1.

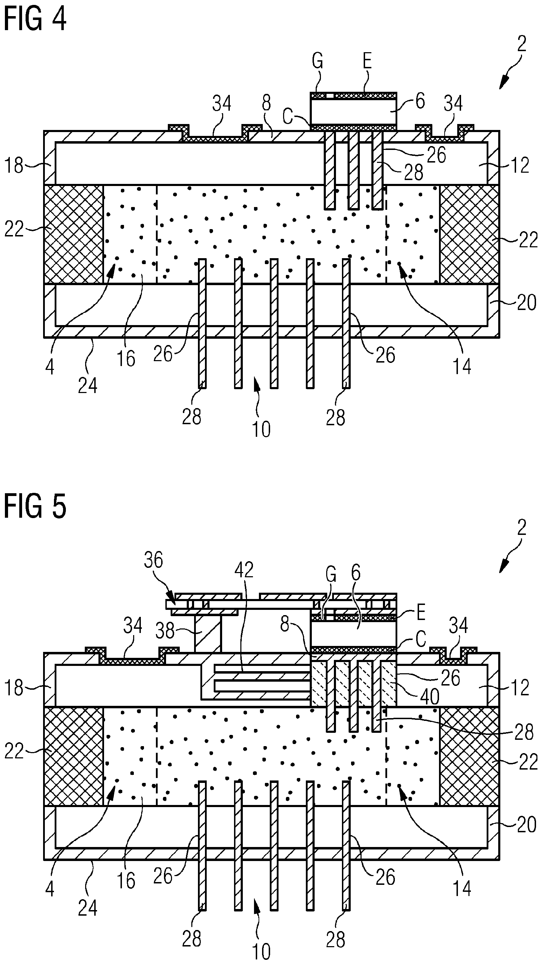

FIG 4 zeigt eine schematische Darstellung einer vierten Ausführungsform eines Elektronikmoduls 2 in einem Querschnitt. Die metallische fluiddichte Beschichtung 18, welche das elektrisch leitfähige Kontaktelement 8 umfasst, weist im Bereich des elektronischen Bauelements 6 Unterbrechungen auf. Um ein Entweichen des Wärmetransportmediums 16 in diesen Bereichen zu verhindern, ist eine fluiddichte dielektrische Beschichtung 34 aufgetragen, welche elektrisch isolierend ausgeführt ist. Eine derartige fluiddichte dielektrische Beschichtung 34 enthält beispielsweise einen keramischen und/oder glasartigen Werkstoff. Keramische und glasartige Werkstoff weisen gute Isolationseigenschaften auf und ermöglichen auch bei sehr geringen Schichtdicken im Bereich von 5-50 µm eine ausreichende Dichtigkeit. Insbesondere ein glasartiger Werkstoff, beispielsweise Siliziumdioxid, kann mittels eines CVD-Verfahrens, insbesondere mittels eines PACVD- Verfahrens (plasma-enhanced chemical vapour deposition, plasmaunterstützte chemische Gasphasenabscheidung) auf einen thermisch stabilen Kunststoff aufgebracht werden, da ein derartiges Verfahren typischerweise bei 200°C bis 500°C stattfinden kann und so der Kunststoff nicht zerstört wird.

Ferner sind unterhalb des elektronischen Bauelements 6 Aussparungen 26 angeordnet, welche durch den Grundkörper 12 verlaufen. Die Aussparungen 26 können zusätzlich durch das elektrisch leitfähigen Kontaktelement 8 verlaufen. In den Aussparungen 26 sind metallische Rippe 28 angeordnet, welche, insbesondere stoffschlüssig, mit dem elektrisch leitfähigen Kontaktelement 8 verbunden sind. Die metallischen Rippen 28 sind beispielsweise aus Kupfer, Aluminium oder eine Legierung, welche mindestens eines dieser Metalle enthält, hergestellt. Weiterhin sind die metallischen Rippen 28 orthogonal in die Kanalstruktur 14 verlaufend angeordnet, sodass die metallischen Rippen 28 in direktem Kontakt mit dem Wärmetransportmedium 16 stehen und als Wärmeleitstrukturen fungieren. Die weitere Ausgestaltung des Elektronikmoduls 2 in FIG 4 entspricht der in FIG 1.

FIG 5 zeigt eine schematische Darstellung einer fünften Ausführungsform eines Elektronikmoduls 2 in einem Querschnitt. Beispielhaft ist das als IGBT ausgeführte elektronische Bauelement 6 mittels planarer Aufbau- und Verbindungstechnik mit einem Substrat 36 verbunden, welches z.B. als Printed Circuit Board (PCB) ausgeführt sein kann. Beispielhaft ist der Kollektor C über ein, insbesondere metallisches, Abstandshalteelement 38, auch Umsteiger genannt, mit dem Substrat 36 verbunden. Alternativ kann der IGBT flip-chip kontaktiert werden.

Der Grundkörper 12 weist im Bereich der Kontaktierung mit dem IGBT eine Aussparung 26 auf, in welcher, beispielhaft drei, metallische Rippen 28 angeordnet sind. Das elektrisch leitfähigen Kontaktelement 8 und die metallischen Rippen 28 sind in FIG 5 exemplarisch einstückig ausgeführt und aus Kupfer, Aluminium oder eine Legierung, welche mindestens eines dieser Metalle enthält, hergestellt, wobei das elektrisch leitfähige Kontaktelement 8, insbesondere stoffschlüssig, mit der fluiddichten metallischen Beschichtung 18 verbunden ist.

Die metallischen Rippen 28, welche im Bereich des IGBTs angeordnet sind, sind von einem offenporigen Metallschaum 40 umgeben, der unter anderem Kupfer enthalten und vom Wärmetransportmedium durchströmt werden kann, wodurch die thermische Anbindung des elektronischen Bauelements 6 an die Heatpipe 4 verbessert wird. Unter anderem ist der Metallschaum 40 mittels eines LCS-Prozesses (Lost Carbonate Sintering) herstellbar. Der Metallschaum 40 kann mittels eines Galvanikprozesses mit dem elektrisch leitfähigen Kontaktelement 8 und/oder den metallischen Rippe 28 verbunden werden. Darüber hinaus sind im Grundkörper 12 zusätzliche Leiterbahnen 42 integriert, welche mit dem elektronischen Bauelement 6 über den Metallschaum 40 kontaktiert sein können und so zu einer Wärmespreizung führen. Ferner ist durch die integrierten Leiterbahnen 42 ein niederinduktiver und/oder miniaturisierter Aufbau realisierbar. Die weitere Ausgestaltung des Elektronikmoduls 2 in FIG 5 entspricht der in FIG 4.

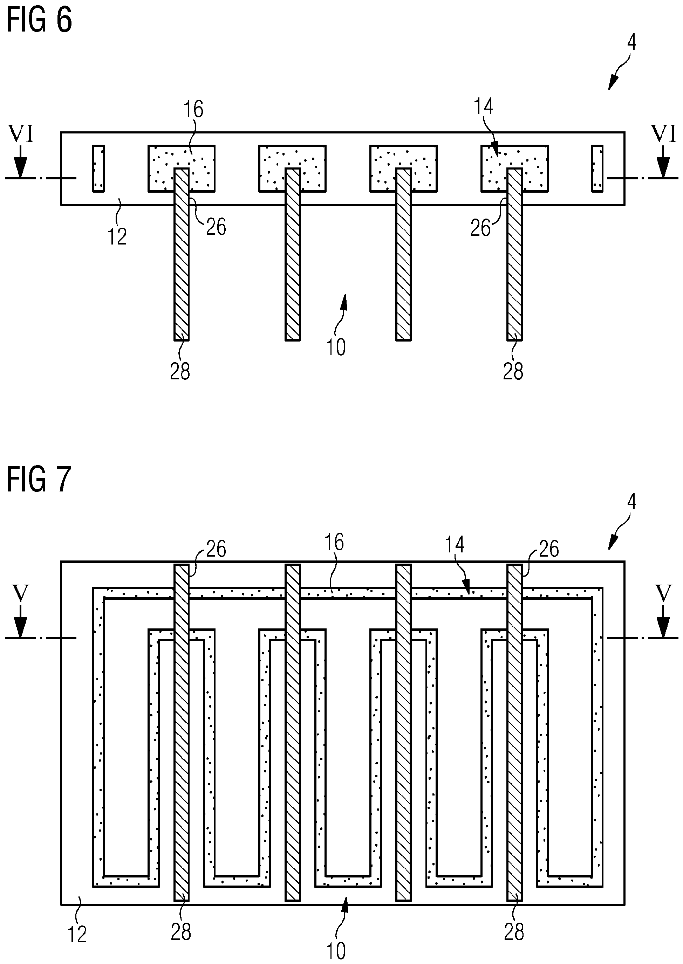

FIG 6 zeigt eine schematische Darstellung eines Grundkörpers 12 einer pulsierenden Heatpipe 4 in einem Querschnitt, welcher aus einem metallischen Werkstoff wie Aluminium, Kupfer oder einer Legierung, welche mindestens eines dieser Metalle enthält, hergestellt ist. FIG 7 zeigt eine schematische Darstellung des Grundkörpers 12 in einem Längsschnitt. Der Grundkörper 12 weist eine planare Kanalstruktur 14 auf, welche einen, insbesondere mäanderartig verlaufenden, geschlossenen Kanal umfasst, Der vollständig im metallischen Grundkörper 12 ausgebildet ist.

Metallische Rippen 28 sind in Aussparungen 26 des Grundkörpers 12 angeordnet und, insbesondere stoffschlüssig, mit dem metallischen Grundkörper 12 verbunden. Alternativ können die metallischen Rippen 28 unter anderem in den Grundkörper 12 eingepresst sein. Ein IGBT kann beispielsweise über ein elektrisch isolierendes und thermisch leitfähiges Substrat, z.B. eine DCB, auf dem metallischen Grundkörper 12 kontaktiert werden. Die metallischen Rippen 28 sind derartig mit dem metallischen Grundkörper 12 verbunden, dass diese in die Kanalstruktur 14 ragen und in direktem Kontakt mit dem Wärmetransportmedium 16 stehen. Die weitere Ausgestaltung der Heatpipe 4 in FIG 6 und FIG 7 entspricht der in FIG 3.

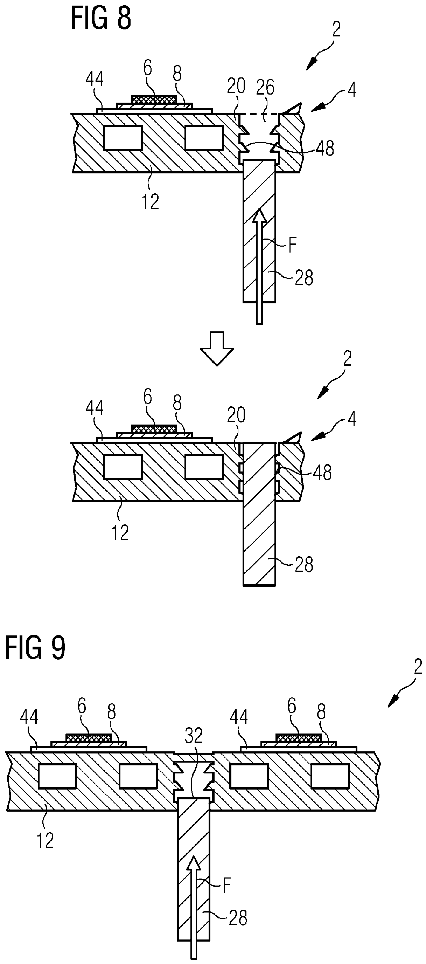

FIG 8 zeigt eine schematische Darstellung eines Verfahrens zur Befestigung einer Rippe 28 in einer Aussparung 26 eines Grundkörpers 12 einer pulsierenden Heatpipe 4 zur Herstellung eines Elektronikmoduls 2. Das elektronische Bauelement 6, welches beispielsweise als IGBT ausgeführt und auf einem elektrisch leitfähigen Kontaktelement 8 kontaktiert ist, wird über eine elektrisch isolierende und thermisch leitfähige dielektrische Lage 44 mit einem metallischen Grundkörper verbunden. Die Rippe 28 ist beispielhaft aus einem metallischen Werkstoff hergestellt und wird in den Grundkörper 12 durch eine Einpresskraft F eingepresst. Beim Einpressen werden Verbindungsmittel 48, z.B. Widerhaken, plastisch verformt. Die Aussparung 26 ist durchgängig ausgeführt. Die Rippe 28 in FIG 8 wird derartig eingepresst, dass diese bündig mit der Oberfläche 20 des Grundkörpers 12 abschließt. Die weitere Ausgestaltung des Elektronikmoduls 2 in FIG 8 entspricht der in FIG 3.

FIG 9 zeigt eine schematische Darstellung eines zweiten Verfahrens zur Befestigung einer Rippe 28 in einer Aussparung 26 eines Grundkörpers einer pulsierenden Heatpipe 4 zur Herstellung eines Elektronikmoduls 2. Die Aussparung 26 ist nicht durchgängig ausgeführt. Die Rippe 28 in FIG 9 wird derartig eingepresst, dass diese den Grundkörpers 12 an einer oberen Kontaktfläche 32 berührt. Die weitere Ausgestaltung des Verfahrens entspricht dem in FIG 8.

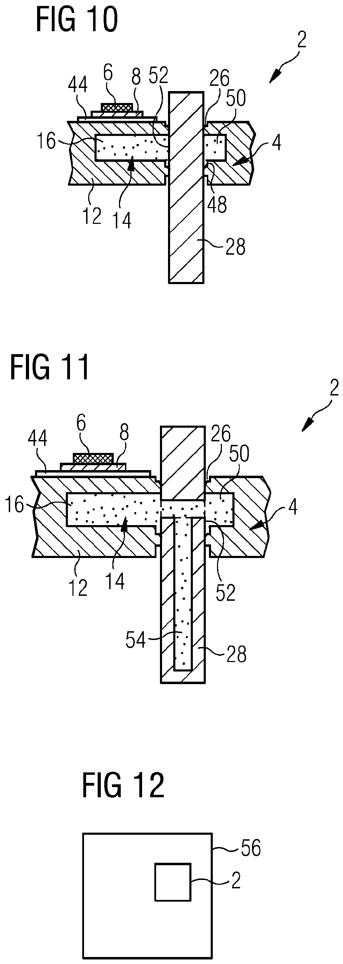

FIG 10 zeigt einen Ausschnitt einer sechsten Ausführungsform eines Elektronikmoduls 2 in einer schematischen Querschnittsdarstellung. Die Aussparung 26 ist durchgängig durch einen Kanal 50 der Kanalstruktur 14 verlaufend ausgeführt, sodass die Rippe 28 über zwei Seitenflächen 52 mit dem Wärmetransportmedium direkt in Kontakt steht und der Kanal 50 durch die Rippe 28 geteilt wird. Die weitere Ausgestaltung des Elektronikmoduls 2 entspricht der in FIG 8.

FIG 11 zeigt einen Ausschnitt einer siebten Ausführungsform eines Elektronikmoduls in einer schematischen Querschnittsdarstellung, wobei die Rippe 28, welche unter anderem aus einem metallischen oder einem dielektrischen Werkstoff hergestellt sein kann, eine Hohlraumstruktur 54 aufweist. Die Hohlraumstruktur 54 der Rippe 28 steht über die Seitenflächen 52 mit dem Wärmetransportmedium 16 aus dem Kanal 50 in einer fluidtechnischen Verbindung. Insbesondere wird so die Hohlraumstruktur 54 der Rippe 28 vom Wärmetransportmedium 16 durchströmt.

FIG 12 zeigt eine schematische Darstellung eines Stromrichters 56, welcher beispielhaft ein Elektronikmodul 2 umfasst.

Zusammenfassend betrifft die Erfindung ein Elektronikmodul 2, umfassend eine pulsierende Heatpipe 4 mit einer Kanalstruktur 14, in der ein Wärmetransportmedium 16 angeordnet ist, und zumindest ein elektronisches Bauelement 6, das mit dem Wärmetransportmedium 16 in einer thermisch leitfähigen Verbindung steht. Um im Vergleich zum Stand der Technik, eine verbesserte Entwärmung zu ermöglichen wird vorgeschlagen, dass die pulsierende Heatpipe 4 wenigstens einen Grundkörper 12 aufweist, in welchem die Kanalstruktur 14 zumindest teilweise ausgebildet ist, wobei der Grundkörper 12 zumindest eine Aussparung 26 aufweist, wobei in der zumindest einen Aussparung 26 jeweils eine Rippe 28, 30 befestigt ist, welche, insbesondere orthogonal, über eine Oberfläche 20 des Grundkörpers 12 hinaussteht.

## Patentansprüche

1. Elektronikmodul (2), umfassend eine pulsierende Heatpipe (4) mit einer Kanalstruktur (14), in der ein Wärmetransportmedium (16) angeordnet ist, und zumindest ein elektronisches Bauelement (6), das mit dem Wärmetransportmedium (16) in einer thermisch leitfähigen Verbindung steht,
wobei die pulsierende Heatpipe (4) wenigstens einen Grundkörper (12) aufweist, in welchem die Kanalstruktur (14) zumindest teilweise ausgebildet ist,
wobei der Grundkörper (12) zumindest eine Aussparung (26) aufweist,
wobei in der zumindest einen Aussparung (26) jeweils eine Rippe (28, 30) befestigt ist, welche, insbesondere orthogonal, über eine Oberfläche (20) des Grundkörpers (12) hinaussteht.

2. Elektronikmodul (2) nach Anspruch 1,
wobei die Rippe (28, 30) aus einem Werkstoff hergestellt ist, welcher eine höhere Wärmeleitfähigkeit aufweist als ein Werkstoff des Grundkörpers (12).

3. Elektronikmodul (2) nach einem der Ansprüche 1 oder 2, wobei die Rippe (28, 30) aus einem metallischen Werkstoff hergestellt ist.

4. Elektronikmodul (2) nach Anspruch 3,
wobei die metallische Rippe (28) einer metallischen Wärmesenke (10) zugeordnet ist.

5. Elektronikmodul (2) nach einem der vorherigen Ansprüche, wobei die Rippe (28, 30) in direktem Kontakt mit dem Wärmetransportmedium (16) steht.

6. Elektronikmodul (2) nach einem der vorherigen Ansprüche, wobei zumindest eine Rippe (28, 30) beidseitig über den Grundkörper (12) hinaussteht.

7. Elektronikmodul (2) nach einem der vorherigen Ansprüche, wobei der Grundkörper (12) der pulsierenden Heatpipe (4) zumindest teilweise aus einem dielektrischen Werkstoff hergestellt ist,
wobei das zumindest eine elektronisches Bauelement (6) über die pulsierende Heatpipe (4) mit einer metallischen Wärmesenke (10) elektrisch isolierend und thermisch leitend verbunden ist.

8. Elektronikmodul (2) nach Anspruch 7,
wobei die zumindest eine Aussparung (26) im dielektrischen Werkstoff des Grundkörpers (12) verlaufend angeordnet ist.

9. Elektronikmodul (2) nach einem der Ansprüche 7 oder 8, wobei der Grundkörper (12) zumindest teilweise fluiddicht beschichtet ist.

10. Elektronikmodul (2) nach Anspruch 9,
wobei der Grundkörper (12) zumindest teilweise mit einem metallischen, keramischen Werkstoff und/oder glasartigen Werkstoff beschichtet ist.

11. Elektronikmodul (2) nach einem der vorherigen Ansprüche, wobei der Grundkörper (12) der pulsierenden Heatpipe (4) zumindest einen fluiddicht ausgeführten Isolationskörper (22) umfasst.

12. Elektronikmodul (2) nach einem der vorherigen Ansprüche, wobei das zumindest ein elektronisches Bauelement (6) über einen Metallschaum (40) mit dem Wärmetransportmedium (16) in Kontakt steht.

13. Elektronikmodul (2) nach Anspruch 12,
wobei zumindest eine, insbesondere metallische, Rippe (28, 30) durch den Metallschaum (40) verlaufend angeordnet ist und in direktem Kontakt mit dem Wärmetransportmedium (16) steht.

14. Elektronikmodul (2) nach einem der vorherigen Ansprüche, wobei zumindest eine Rippe (28, 30) kraftschlüssig, insbesondere über eine Pressverbindung, in der Aussparung (26) befestigt ist.

15. Stromrichter (56) mit mindestens einem Elektronikmodul (2) nach einem der vorherigen Ansprüche.

16. Verfahren zur Herstellung eines Elektronikmoduls (2), umfassend eine pulsierende Heatpipe (4) mit einer Kanalstruktur (14), in der ein Wärmetransportmedium (16) angeordnet ist, und zumindest ein elektronisches Bauelement (6), das mit dem Wärmetransportmedium (16) in einer thermisch leitfähigen Verbindung steht,
wobei die pulsierende Heatpipe (4) wenigstens einen Grundkörper (12) aufweist, in welchem die Kanalstruktur (14) zumindest teilweise ausgebildet ist,
wobei in den Grundkörper (12) zumindest eine Aussparung (26) eingebracht wird,
wobei in der zumindest einen Aussparung (26) eine Rippe (28, 30) befestigt wird, welche, insbesondere orthogonal, über eine Oberfläche (20) des Grundkörpers (12) hinausstehend angeordnet wird.
